# FASCICULE DE BREVET EUROPEEN

(11) **EP 3 698 466 B1**
(45) Date de publication et mention de la délivrance du brevet: **11.08.2021**
(21) Numéro de dépôt: 18788759.1
(22) Date de dépôt: 17.10.2018
(51) Int. Cl.: H03B 17/00

(54) **OSCILLATEUR RADIOFREQUENCE AMELIORE**
VERBESSERTER HOCHFREQUENZOSZILLATOR
IMPROVED RADIO FREQUENCY OSCILLATOR

(30) Priorité: 17.10.2017 FR 1701082
(43) Date de publication de la demande: 26.08.2020
(73) Titulaire: Thales, 92400 Courbevoie (FR); Centre National de la Recherche Scientifique, 75016 Paris (FR); Université de Paris, 75006 Paris (FR)
(72) Inventeur: DOLFI, Daniel, 91767 Palaiseau Cedex (FR); COMBRIE, Sylvain, 91767 Palaiseau Cedex (FR); MORVAN, Loic, 91767 Palaiseau Cedex (FR); BRAIVE, Remy, 75013 Paris (FR); ROBERT, Isabelle, 75794 Paris Cedex 16 (FR); BEUGNOT, Jean-Charles, 75794 Paris Cedex 16 (FR); BENCHABANE, Sarah, 75794 PARIS CEDEX 16 (FR); LAUDE, Vincent, 75794 PARIS CEDEX 16 (FR)
(74) Mandataire: Lavoix
(86) Numéro de dépôt international: PCT/EP2018/078410
(87) Numéro de publication internationale: WO 2019/076983

(56) Documents cités:
- EP-A1- 3 112 879
- US-A- 4 733 561
- US-A1- 2012 294 564
- US-A1- 2014 313 559
- US-A1- 2017 089 944

## Description

La présente invention a pour domaine celui des oscillateurs radiofréquence ou RF. Le domaine RF s'étend typiquement entre 1 et 100 GHz.

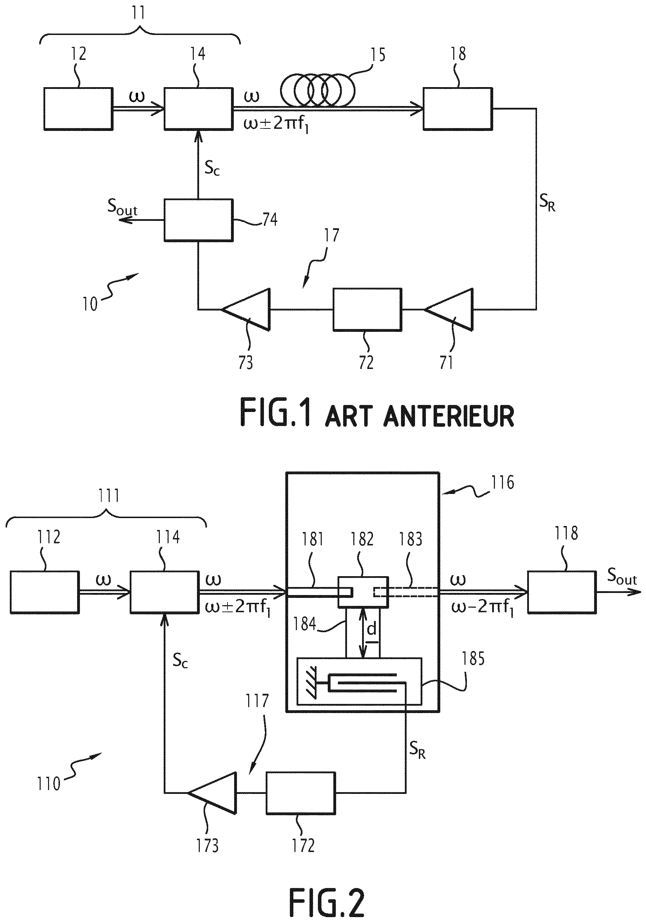

L'article de X. S. YAO and L. MALEKI, "Optoelectronic oscillator for photonic systems," IEEE J. Quantum Electron., vol. 32, no. 7, pp. 1141-1149, 1996, divulgue un oscillateur RF du type opto-électronique. Comme représenté sur la figure 1, cet oscillateur 10, qui constitue une liaison optoélectronique large bande à modulation externe, rebouclée sur elle-même, comporte :
- une source commandée 11, constituée d'un laser 12, propre à générer un faisceau lumineux mono-fréquence, dont l'onde optique possède une pulsation *ω* ; et d'un modulateur 14, rapide, propre à moduler le faisceau lumineux mono-fréquence du laser 12, selon un signal de commande Sc de fréquence f₁, de manière à générer un faisceau lumineux modulé comportant des ondes optiques aux pulsations *ω* et *ω* ± 2*πf*₁ ;
- une fibre optique 15, formant une ligne à retard pour le faisceau lumineux modulé généré par la source commandée, dont la longueur L est adaptée pour retarder les ondes optiques la traversant ;
- une photodiode 18, rapide, propre à délivrer un signal électrique à la fréquence f₁ à partir du faisceau lumineux retardé émergeant de la fibre 15 ; et,
- une boucle de commande 17, traitant le signal électrique délivré en sortie de la photodiode 18 pour obtenir un signal de contre-réaction appliqué en tant que signal de commande au modulateur 14.

La boucle de commande 17 comporte des moyens de filtrage (tel qu'une cavité résonnante 72) et d'amplification (tel qu'un amplificateur faible bruit 71 en entrée de la cavité et un amplificateur forte puissance 73 en sortie de la cavité), ainsi qu'un coupleur 74, dont une première sortie est connectée à la borne de commande du modulateur 14 et dont une seconde sortie porte le signal utile Sout généré par l'oscillateur 10. Le signal utile Sout oscille à la fréquence f₁.

Lorsque les conditions d'oscillation sont atteintes (c'est-à-dire lorsque le gain total de la boucle est suffisant), le facteur de qualité Q d'un tel oscillateur est une fonction du rapport entre la longueur L de la fibre optique 15, sur la longueur d'onde A dans le vide associée à la fréquence d'oscillation f₁.

Ainsi, pour une oscillation à une fréquence f₁ dans le domaine RF, par exemple de 10 GHz (A = 3 cm) et avec une longueur L = 3 km, on atteint un facteur de qualité Q de 10⁵. Ce facteur de qualité est intéressant au sens où il permet de générer des signaux utiles de grande pureté spectrale (typiquement - 145 dBc/Hz à 10 kHz de la porteuse).

Cependant, le volume final d'un tel oscillateur RF optoélectronique est de l'ordre de 0,5 à 1 litre, du fait des contraintes de bobinage de la fibre optique. Ceci constitue un handicap pour certaines applications embarquées, dans des antennes radar par exemple.

De plus, la longueur importante de la fibre optique rend l'oscillateur relativement sensible aux variations de température et aux vibrations, ce qui est désavantageux pour des applications embarquées.

On peut partiellement y remédier en remplaçant la fibre optique par un résonateur optique. Celui-ci introduit un retard entre l'onde optique incidente et l'onde optique émergeante. A ce jour, les seuls résonateurs optiques présentant les coefficients de surtension suffisants, typiquement de l'ordre de 10⁸, sont des résonateurs tridimensionnels.

Cependant, le couplage entre le modulateur et le résonateur optique, d'une part, et le nécessaire verrouillage de la longueur d'onde du laser sur celle du résonateur optique, d'autre part, sont critiques et sont également relativement sensibles à l'environnement (la température, les vibrations, etc.)

Par ailleurs, il existe des oscillateurs à stabilisation (aussi dénommés à verrouillage) intégrant un résonateur optomécanique. Un tel résonateur met en œuvre un couplage entre une résonance optique et une résonance mécanique. Le faisceau optique émergeant du résonateur est utilisé pour élaborer une contre-réaction dans le domaine basse fréquence et l'appliquer au laser (fréquence et/ou puissance) afin de stabiliser le point de fonctionnement de l'oscillateur vis-à-vis des dérives lentes de la fréquence d'oscillation (température, vibrations, etc.) Cependant, les facteurs de qualité mécaniques restent faibles et leur pureté spectrale est donc faible.

Par ailleurs, le document EP 3 112 879 A1 divulgue un oscillateur radiofréquence, comportant : une source commandée propre à générer un faisceau lumineux incident comportant au moins une onde optique à une pulsation de référence *ω* ; un résonateur optomécanique, présentant une résonance optique à la pulsation de référence *ω* et une résonance mécanique à une fréquence de référence f₁, le résonateur optomécanique étant propre, à partir du faisceau lumineux incident à générer, d'une part, un faisceau lumineux émergeant comportant des ondes optiques aux pulsations *ω* et *ω* - 2*πf*₁, et, d'autre part, une onde acoustique à la fréquence de référence f₁ ; une photodiode, propre à délivrer un signal électrique utile à la fréquence de référence f₁ à partir du faisceau lumineux émergeant du résonateur optomécanique.

De plus, les documents US4733561 A, US2017/089944 A1, US2014/313559 A1 et US2012/294564 A1 divulguent d'autres oscillateurs avec un résonateur optomécanique.

Le but de la présente invention est de résoudre les problèmes précités.

Pour cela l'invention a pour objet un oscillateur radiofréquence, comportant :
- une source commandée propre à générer un faisceau lumineux incident comportant au moins une onde optique à une pulsation de référence *ω* ;
- un résonateur optomécanique, présentant une résonance optique à la pulsation de référence *ω* et une résonance mécanique à une fréquence de référence f₁, le résonateur optomécanique étant propre, à partir du faisceau lumineux incident à générer, d'une part, un faisceau lumineux émergeant comportant des ondes optiques aux pulsations *ω* et *ω* - 2*πf*₁, et, d'autre part, une onde acoustique à la fréquence de référence f₁ ;
- une photodiode, propre à délivrer un signal électrique utile à la fréquence de référence f₁ à partir du faisceau lumineux émergeant du résonateur optomécanique,
caractérisé en ce qu'il comporte :
- un moyen de propagation acoustique propre à prélever l'onde acoustique générée par le résonateur optomécanique et à la propager sur une distance de propagation prédéterminée pour y introduire un retard de manière à produire une onde acoustique retardée ;
- un moyen de conversion propre à convertir l'onde acoustique retardée en sortie du moyen de propagation, en un signal électrique de retard ayant une fréquence d'oscillation égale à la fréquence de référence f₁ ; et,
- une boucle de commande, propre à traiter le signal de retard pour obtenir un signal électrique de commande appliqué à la source, le signal électrique de commande ayant une fréquence d'oscillation égale à la fréquence de référence f₁.

La présente invention met également en œuvre un résonateur optomécanique, c'est-à-dire un dispositif qui combine une résonance optique, une résonance mécanique et un couplage entre celles-ci.

Cependant, la présente invention propose un schéma original permettant un affinement spectral (c'est-à-dire une augmentation de la pureté spectrale) d'un oscillateur optomécanique par une réinjection retardée du signal haute fréquence, le retard étant réalisé non plus par la propagation d'une onde optique (dans une fibre optique ou un résonateur optique), mais par la propagation d'une onde acoustique (dans un guide d'onde acoustique par exemple) générée optiquement dans le résonateur optomécanique.

L'onde acoustique retardée est ensuite collectée, dans le domaine électrique, par un moyen adapté réalisant une conversion de l'onde acoustique en un signal électrique (tension ou courant). Il s'agit par exemple d'un moyen mettant en œuvre un effet piézo-électrique ou un effet capacitif. Cette conversion peut être réalisée par une propriété physique du matériau constitutif du résonateur optomécanique ou bien par une structure adaptée qui est rapportée sur le résonateur optomécanique. Le signal électrique ainsi généré est alors réinjecté de manière à moduler l'onde optique entrant dans le résonateur optomécanique.

Ainsi l'oscillateur apparait comme un oscillateur RF opto-acousto-électronique.

Suivant des modes particuliers de réalisation, l'un ou l'autre des oscillateurs précédents comporte une ou plusieurs des caractéristiques suivantes, prises isolément ou suivant toutes les combinaisons techniquement possibles :
- la source comporte : un laser mono-fréquence, propre à générer un faisceau lumineux comportant une onde optique à la pulsation de référence *ω* ; et un modulateur propre à moduler l'onde optique du faisceau lumineux générée par le laser mono-fréquence selon ledit signal électrique de commande pour obtenir en sortie un faisceau lumineux incident modulé de manière à comporter des ondes optiques à la pulsation *ω* et aux pulsations *ω* + 2*πf*₁ et/ou *ω* - 2*πf*₁.
- la source est un laser bi-fréquence, propre à générer, selon ledit signal de commande, un faisceau lumineux incident comportant des ondes optiques à la pulsation *ω* et aux pulsations *ω* + 2*πf*₁ et/ou *ω* - 2*πf*₁*.*
- le moyen de propagation étant un premier moyen de propagation propre à produire une première onde acoustique retardée d'un premier retard et le moyen de conversion étant un premier moyen de conversion propre à délivrer un premier signal électrique de retard à partir de la première onde acoustique retardée, l'oscillateur comporte en outre un second moyen de propagation propre à prélever l'onde acoustique générée par le résonateur optomécanique et à la propager sur une distance de propagation prédéterminée pour y introduire un second retard de manière à produire une seconde onde acoustique retardée et un second moyen de conversion propre à délivrer un second signal électrique de retard à partir de la seconde onde acoustique retardée, la boucle de commande comportant un moyen de détermination d'un signal électrique d'erreur élaboré à partir des premier et second signaux électriques de retard, le signal de commande étant élaboré à partir du signal d'erreur.
- le résonateur optomécanique, le moyen de propagation acoustique et le moyen de conversion sont intégrés sur une même puce.
- le moyen de propagation acoustique est un guide d'onde accordé à la fréquence de référence f₁.
- le moyen de conversion comporte un matériau piézoélectrique et des électrodes interdigitées.

Compte tenu des vitesses usuelles de propagation acoustique dans les matériaux, il est possible de réaliser un retard équivalent à celui d'une fibre optique de quelques centaines de mètres sur une distance de quelques millimètres. Les fonctions de l'oscillateur RF présenté ci-dessus possèdent l'avantage de pouvoir être intégrées sur une unique puce (aussi dénommé circuit intégré) de faibles dimensions (quelques dizaines de millimètres carrés) avec des technologies de réalisation collectives et planaires.

L'invention et ses avantages seront mieux compris à la lecture de la description détaillée qui va suivre de plusieurs modes de réalisation particuliers de l'invention, donnés uniquement à titre d'exemples illustratifs et non limitatifs. Cette description est faite en se référant aux dessins annexés sur lesquels :
- La figure 1 représente schématiquement un oscillateur selon l'état de la technique ;
- La figure 2 représente schématiquement un premier mode de réalisation d'un oscillateur selon l'invention ;
- La figure 3 représente schématiquement un second mode de réalisation d'un oscillateur selon l'invention ;
- La figure 4 représente schématiquement un troisième mode de réalisation d'un oscillateur selon l'invention ; et,
- La figure 5 représente schématiquement un quatrième mode de réalisation d'un oscillateur qui n'est pas conforme à l'invention.

En référence à la figure 2, la structure d'un mode de réalisation actuellement préféré d'un oscillateur radiofréquence selon l'invention va être décrite.

L'oscillateur radiofréquence 110 comporte une source commandée 111, un dispositif opto-acousto-électrique 116, une boucle de réinjection 117 et une photodiode 118.

Plus précisément, la source commandée 111 est constituée d'un laser 112 et d'un modulateur 114.

Le laser 112 est un laser mono-fréquence, propre à générer un faisceau lumineux comportant une onde optique à une pulsation *ω*. Le laser 112 est par exemple du type diode laser DFB (selon l'acronyme anglais de « distributed feedback laser ») ou laser à état solide pompé par diode. Il est propre à générer un faisceau laser dont la lumière présente, par exemple, une longueur d'onde de 1,5 µm. Le faisceau lumineux en sortie du laser 112 est appliqué en entrée du modulateur 114.

Le modulateur 114 est rapide et propre à moduler l'onde optique du faisceau lumineux émis par le laser 112 selon un signal de commande Sc ayant une fréquence f₁, de manière à générer en sortie un faisceau lumineux modulé comportant des ondes optiques aux pulsations *ω* et *ω* ∓ 2*πf*₁.

Par exemple, le modulateur 114 est un modulateur électro-optique rapide, dont la bande passante est compatible de la fréquence d'oscillation RF recherchée (typiquement f₁=10 GHz). Le modulateur 114 est, de préférence, un modulateur d'intensité, par exemple du type Mach-Zehnder. En variante, il pourrait s'agir tout aussi bien d'un modulateur de phase ou d'un modulateur à bande latérale unique. Le modulateur 114 est propre à moduler l'intensité ou la phase du faisceau laser incident conformément au niveau en tension du signal de commande Sc appliqué sur une borne de contrôle du modulateur 114. Un faisceau lumineux modulé est obtenu en sortie du modulateur 114.

Le faisceau lumineux modulé en sortie du modulateur 114 est appliqué en entrée du dispositif 116.

Le dispositif opto-acousto-électrique 116 comporte un résonateur optomécanique 182, un guide acoustique 184 et un transducteur mécanique / électrique 185.

Le résonateur optomécanique 182 présente à la fois une résonance optique à la pulsation *ω*, et une résonance mécanique à la fréquence f_{1;} ces résonances étant couplées entre elles. A partir d'un faisceau optique incident à une pulsation proche de la pulsation *ω*, le résonateur 182 est propre à générer une oscillation mécanique à sa fréquence de résonance mécanique naturelle, f₁, ainsi qu'un faisceau lumineux émergeant comportant des ondes optiques aux pulsations *ω* et *ω* - 2*πf*₁.

Un tel résonateur optomécanique est connu et est par exemple présenté en détail dans l'article de Markus Aspelmeyer et al. « cavity optomechanics », Reviews of Modern Physics, Vol. 86, Octobre-Décembre 2014.

Le résonateur optomécanique 182 est une membrane au sens où sa dimension d'épaisseur (par exemple de 250 nm) est réduite par rapport à ses dimensions de longueur et de largeur.

Cette membrane est réalisée à partir d'un matériau structuré à l'échelle nanométrique de manière à présenter un motif optique périodique (permettant de définir une bande interdite photonique), dont la périodicité est altérée afin de présenter un défaut de manière à former une cavité optique ayant une grande finesse spectrale.

La structuration photonique de la membrane permet d'exciter (via un couplage optomécanique du type pression de radiation, diffusion Brillouin stimulée,...) une vibration mécanique, à partir d'un faisceau lumineux ayant un niveau de puissance optique faible (typiquement de quelques 10 mW). Ainsi, grâce à cet effet optomécanique, les ondes optiques du faisceau lumineux incident excitent, dans le résonateur 182, des modes de vibration mécanique, c'est-à-dire des ondes acoustiques.

En retour, ces ondes acoustiques modifient localement l'indice optique effectif de la membrane. Cette modification de l'indice, variable dans le temps, crée des ondes optiques secondaires à partir des ondes optiques du faisceau lumineux incident. Ces ondes optiques secondaires possèdent des fréquences optiques différentes de celles des ondes optiques du faisceau incident.

Ainsi, lorsqu'un équilibre est trouvé, si la pulsation de l'onde optique du faisceau indicent est *ω* et si les fréquences des modes de vibration mécanique de la membrane sont f₁, f₂,..., fᵢ,..., le faisceau lumineux émergeant est composé d'ondes optiques présentant des pulsations: ω ; ω - 2πf₁ ; ω - 2πf₂ ; ... ; ω - 2πfᵢ ;... Normalement, uniquement des bandes latérales inférieures sont produites, mais il n'est pas exclu que certains matériaux permettent d'obtenir des bandes latérales supérieures.

En outre, le matériau de la membrane constitutive du résonateur 182 est de préférence structuré selon un motif acoustique. Celui-ci est par exemple obtenu en réalisant des nano perforations de la membrane. Chaque perforation peut alors être considérée comme une rupture d'impédance acoustique, de sorte que le matériau de la membrane constitue un cristal phononique. Le matériau associant alors des fonctions optique et acoustique est dit « phoxonique ».

La structuration acoustique de la membrane est propre à assurer le filtrage d'un mode de vibration mécanique privilégié et le confinement d'une onde optique privilégiée. La structuration acoustique de la membrane est ainsi choisie de manière à privilégier le mode de vibration mécanique caractérisé par la fréquence f₁.

Ainsi, en régime établi, l'onde acoustique à la fréquence f₁ est renforcée et est sélectionnée parmi les différentes ondes acoustiques possibles. Simultanément, l'onde optique à la pulsation *ω* - 2*πf*₁ est privilégiée. Ainsi, en sortie du résonateur 182 et par conséquent du dispositif 116, on dispose d'un faisceau émergeant contenant les ondes optiques de pulsation *ω* et *ω* - 2*πf*₁*.*

Par ailleurs, l'onde acoustique de fréquence f₁ est utilisée pour générer un signal de retard Sr.

Pour cela, le guide acoustique 184 du dispositif 116 est propre à prélever l'onde acoustique de fréquence f₁ générée dans la membrane constitutive du résonateur optomécanique 182 et à la guider sur une distance d vers le transducteur mécanique / électrique 185.

Le temps de propagation de l'onde acoustique de fréquence f₁ à travers le guide acoustique 184 introduit un retard *τ*. Compte tenu de la vitesse de l'onde acoustique (de l'ordre de 3000 m.s⁻¹) dans le matériau constitutif du guide d'onde, on obtient un retard de l'ordre de 1 µs pour une distance d de 3 mm.

Le matériau du guide acoustique 184 présente avantageusement une structuration nano-phononique qui ralentit et filtre cette onde acoustique. Par exemple, il est structuré sous la forme d'un matériau à bande interdite phononique de façon à ralentir l'onde acoustique à la fréquence f₁, typiquement jusqu'à des valeurs de 400 m.s⁻¹. Un tel matériau est par exemple présenté dans l'article de Fang, Kejie, et al. "Phonon routing in integrated optomechanical cavity-waveguide systems." arXiv preprint arXiv:1508.05138 (2015). Dans ce cas, on obtient un retard de 1 µs pour une distance d de propagation de 0,4 mm. A noter que dans une architecture d'oscillateur optoélectronique selon l'état de la technique le même retard est obtenu avec 200 m de fibre optique.

Enfin, à l'autre extrémité du guide acoustique 184, le transducteur mécanique / électrique 185 a pour fonction de convertir l'onde acoustique retardée de fréquence f₁ en un signal électrique Sr, qui possède une fréquence d'oscillation égale à la fréquence privilégiée f₁. Ceci peut être par exemple obtenu en choisissant le matériau constitutif du substrat du transducteur 185 de manière à ce qu'il soit piézo-électrique. Le substrat porte alors, en surface, un ensemble d'électrodes inter-digitées. Cet ensemble d'électrodes est accordé à la fréquence f₁.

De préférence, le dispositif 116 comporte également un guide optique d'entrée 181 et un guide optique de sortie 183, disposés à proximité du résonateur 182. Le guide optique d'entrée a pour fonction de guider jusqu'au résonateur 182 le faisceau lumineux incident, généré par la source commandée 111 et appliqué en entrée du dispositif 116. Le couplage entre le guide 181 et le résonateur 182 s'effectue par ondes évanescentes. De manière symétrique, le guide optique de sortie 183 a pour fonction de guider le faisceau lumineux émergeant du résonateur 182 jusqu'à la sortie du dispositif 116, vers la diode 118. Le couplage entre le résonateur 182 et le guide optique de sortie 183 est également du type par ondes évanescentes. Avantageusement, les guides optiques peuvent être réalisés directement dans la membrane constitutive du résonateur 182.

Dans une variante particulièrement avantageuse, les différentes fonctionnalités du dispositif 116 sont intégrées sur une même puce. Les matériaux constitutifs de la membrane du résonateur 182, du guide acoustique 184 et du substrat du transducteur 185 sont alors identiques de manière à permettre une fabrication simultanée au moyen d'une technologie adaptée. Le matériau envisagé est par exemple un matériau semi-conducteur III-V, de préférence de l'Arséniure de Gallium GaAs.

La photodiode 118 permet de générer un signal utile Sₒᵤₜ à partir du faisceau lumineux émergeant du dispositif 116.

La photodiode 118 est de préférence une photodiode rapide, c'est-à-dire dont la bande passante est supérieure à la fréquence f₁. Elle a pour fonction de détecter l'écart de fréquence entre les deux ondes optiques du faisceau lumineux émergeant, respectivement *ω* et *ω* - 2*πf*₁, et de délivrer en sortie un signal électrique de battement à la fréquence f₁. C'est ce signal de battement qui est le signal utile Sₒᵤₜ délivré en sortie de l'oscillateur 110.

La photodiode 118 peut avantageusement être utilisée pour stabiliser les conditions de fonctionnement du résonateur optomécanique 182, via la puissance et la fréquence optique du laser. Elle permet par exemple de compenser les dérives thermiques du résonateur optique qui entraînent un désaccord de la résonance vis-à-vis de l'excitation.

La boucle de réinjection 117 élabore le signal électrique de commande Sc du modulateur 114 à partir du signal électrique Sr délivré en sortie du transducteur 185. La boucle 117 comporte un moyen de filtrage 172 suivi d'un moyen d'amplification 173.

Ainsi, le signal électrique Sᵣ, retardé et de fréquence f1, est utilisé via la boucle de réinjection 117, pour alimenter le modulateur 114. On réinjecte donc dans le résonateur optomécanique 182 un faisceau lumineux de pulsation *ω* modulé à la fréquence f₁, c'est-à-dire comportant des ondes optiques aux pulsations ω et ω ∓ 2πf₁.

On pourrait aussi récupérer le signal de battement radiofréquence en sortie de l'amplificateur 173 à l'aide d'un coupleur, identique au coupleur 74.

Les deux ondes optiques *ω* et *ω* - 2*πf*₁ contenues dans le faisceau modulé injecté dans le résonateur 182 contribuent à entretenir la génération de l'onde acoustique à la fréquence f₁.

De cette manière, l'oscillation optomécanique 182 gagne en finesse grâce au facteur de qualité effectif offert par le délai acoustique *τ*.

L'oscillation à f₁ portée successivement optiquement, mécaniquement, et électriquement bénéficie à la fois d'une résonance optique, d'une résonance mécanique, et d'un délai acoustique. L'ensemble constitue donc un oscillateur RF plus apte à générer des signaux de grande pureté spectrale qu'une simple résonance optomécanique .

Le retard étant obtenu par une structure de quelques millimètres, l'oscillateur présente un volume extrêmement réduit, notamment par rapport à l'état de la technique. Le volume du résonateur opto-mécanique est typiquement de quelques µm³. Celui de l'oscillateur, intégrant la ligne à retard et le transducteur, est typiquement de 1mmx10µmx250nm.

Le résonateur 182 présente également un coefficient de surtension optique Q élevé, typiquement de l'ordre de 10⁵- 10⁶.

Dès lors que le gain électrique et la puissance optique (typiquement 10 mW) sont suffisants, on peut atteindre des conditions d'oscillations entretenues et un affinement spectral de l'oscillateur 110 électro-optomécanique.

La fréquence f₁ est élevée, typiquement de l'ordre du GHz.

En variante, une fibre optique peut être insérée entre le dispositif 116 et la photodiode 118 afin de distribuer le signal RF sur porteuse optique du faisceau lumineux émergeant loin du cœur de l'oscillateur 110. Dans cette variante la fibre optique ne joue aucun rôle dans la stabilisation de l'oscillateur, contrairement à l'état de la technique.

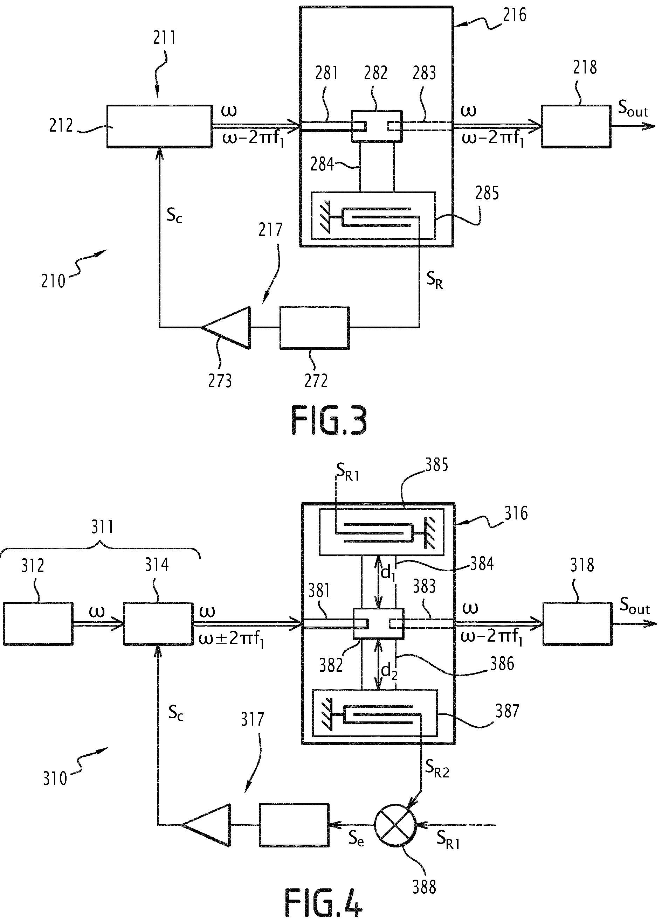

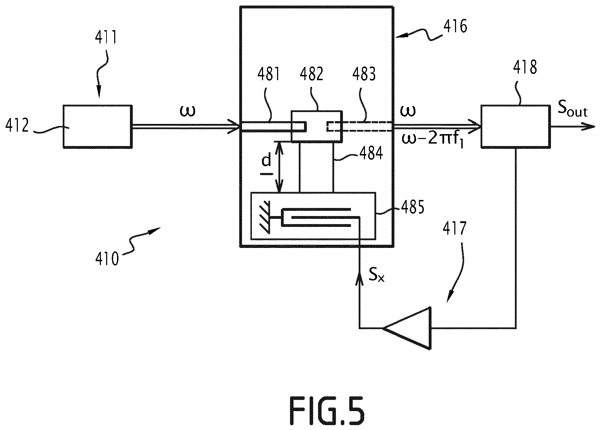

Les figures 3 à 4 représentent un second et troisième mode de réalisation alternatif de l'invention tandis que la figure 5 représente un quatrième mode de réalisation qui ne relève pas de l'invention. Un élément du second, troisième ou quatrième mode de réalisation qui est identique à un élément du premier mode de réalisation est référencé sur ces figures par le chiffre utilisé pour référencer cet élément identique sur la figure 2 augmenté d'une centaine pour le second mode de réalisation, de deux centaines pour le troisième mode de réalisation et de trois centaines pour le quatrième mode de réalisation.

Dans le second mode de réalisation de la figure 3, toutes choses égales par ailleurs, la source 211 de l'oscillateur 210 est un laser bi-fréquence 212 en remplacement de l'ensemble constitué du laser 112 et du modulateur 114 de l'oscillateur 110 de la figure 2. Dans le cas où le laser bi-fréquence est une diode laser du type de celles présentées dans l'article de G. Kervella et al. "Laser sources for microwave to millimeter-wave applications," Photon. Res. 2, B70-B79 (2014), le signal électrique de commande S_{c}, d'origine acoustique, peut être appliqué directement pour contrôler le laser bi-fréquence et verrouiller, à la fréquence f₁, l'écart entre les deux fréquences générées par le laser. Le laser bi-fréquence génère ainsi uniquement deux ondes optiques respectivement à *ω* et à *ω* - 2*πf*₁.

En variante de ce second mode de réalisation, la source 211 est un laser à modulation directe.

Dans le troisième mode de réalisation de la figure 4, correspondant à une variante de réalisation du premier mode de réalisation de la figure 2, la source 311 de l'oscillateur 310 est constituée par un laser mono-fréquence 312 et un modulateur 314.

Dans ce mode de réalisation, le résonateur optomécanique 316 comporte un premier guide acoustique 384 (propageant l'onde acoustique sur une distance d₁) et un premier convertisseur mécanique / optique 385 permettant de générer un premier signal de retard Sᵣ₁ ayant un retard *τ*1 et un second guide acoustique 386 (propageant l'onde acoustique sur une distance d₂) et un second convertisseur mécanique / optique 387 permettant de générer un second signal de retard Sᵣ₂ ayant un retard *τ*2.

Les deux signaux de retard sont combinés dans un additionneur RF 388. Ce dernier délivre alors un signal d'erreur Sₑ ayant une fréquence réduite, qui rend compte des dérives de la fréquence de battement entre deux instants, séparés de l'écart temporel *τ*2 - *τ*1. Le signal d'erreur Sₑ est ensuite amplifié de manière à obtenir le signal de commande S_{c} de la source 311.

En variante de ce troisième mode de réalisation, le retard *τ*1 n'est pas obtenu acoustiquement, mais à partir du signal utile Sₒᵤₜ en sortie de la photodiode 318. C'est ce dernier qui est mélangé au signal retardé acoustiquement Sᵣ₂, afin de générer le signal d'erreur Sₑ de contre-réaction sur le laser bi-fréquence.

Dans le quatrième mode de réalisation ne relevant pas de l'invention et représenté sur la figure 5, le modulateur électro-optique est supprimé. L'onde optique de la source 411 est injectée directement depuis le laser 412 dans le résonateur 482. Cette onde optique incidente est modulée par la vibration mécanique et l'onde modulée émergeante est détectée, en sortie du résonateur 482 par la photodiode rapide 418. Le signal utile Sₒᵤₜ délivré en sortie de la diode 418 est alors amplifié pour obtenir un signal d'excitation Sₓ à la fréquence f₁. Le signal d'excitation Sₓ est ensuite appliqué à un ensemble d'électrodes inter-digitées d'un convertisseur 485 fonctionnant maintenant en tant que convertisseur électrique-acoustique. Il excite, par effet piézo-électrique, une onde acoustique à la fréquence f₁. Cette onde acoustique est prélevée et guidée par un guide acoustique 484 vers le résonateur 482. C'est cette onde acoustique qui agira, avec un retard *τ* introduit par la propagation de l'onde acoustique à travers le guide acoustique 484, sur la cavité optique du résonateur 482 pour moduler l'onde optique.

Dans quatrième mode de réalisation, une onde acoustique, générée par un signal électrique, est « relue » optiquement. La détection, par la photodiode, de cette onde optique modulée donne un signal électrique qui alimente lui-même la génération de l'onde acoustique. L'oscillateur 410 est ainsi refermé.

Ce quatrième mode de réalisation est « inverse » de celui des figures précédentes, qui elles illustrent trois modes de réalisation selon l'invention. Ce quatrième mode de réalisation est généralisable à l'ensemble des trois modes de réalisation et variantes de l'invention présentés précédemment.

L'oscillateur selon l'invention permet la génération de signaux RF de grande pureté spectrale, et ceci directement à la fréquence d'utilisation, notamment sans avoir besoin de chaine de multiplication.

L'oscillateur selon l'invention peut être réalisé sur une puce de semi-conducteur de l'ordre de 1 à 10 cm², compatible des applications embarquées.

La présente invention s'inscrit dans le domaine général de la génération de signaux RF de grande pureté spectrale pouvant être utilisés comme oscillateur local dans des systèmes radar, de guerre électronique, de communication ou plus généralement de métrologie.

## Revendications

1. Oscillateur radiofréquence (110), comportant :
- une source (111) commandée propre à générer un faisceau lumineux incident comportant au moins une onde optique à une pulsation de référence *ω* ;
- un résonateur optomécanique (182), présentant une résonance optique à la pulsation de référence *ω* et une résonance mécanique à une fréquence de référence f₁, le résonateur optomécanique étant propre, à partir du faisceau lumineux incident à générer, d'une part, un faisceau lumineux émergeant comportant des ondes optiques aux pulsations *ω* et *ω* - 2*πf*₁, et, d'autre part, une onde acoustique à la fréquence de référence f₁ ;
- une photodiode (118), propre à délivrer un signal électrique utile (Sₒᵤₜ) à la fréquence de référence f₁ à partir du faisceau lumineux émergeant du résonateur optomécanique (182),
**caractérisé en ce qu'**il comporte :
- un moyen de propagation acoustique (184) propre à prélever l'onde acoustique générée par le résonateur optomécanique (182) et à la propager sur une distance de propagation (d) prédéterminée pour y introduire un retard (*τ*) de manière à produire une onde acoustique retardée ;
- un moyen de conversion (185) propre à convertir l'onde acoustique retardée en sortie du moyen de propagation, en un signal électrique de retard (Sᵣ) ayant une fréquence d'oscillation égale à la fréquence de référence f₁ ; et,
- une boucle de commande (117), propre à traiter le signal de retard (Sᵣ) pour obtenir un signal électrique de commande (S_{c}) appliqué à la source (111), le signal électrique de commande ayant une fréquence d'oscillation égale à la fréquence de référence f₁.

2. Oscillateur (110) selon la revendication 1, dans lequel la source (111) comporte :
- un laser mono-fréquence (112), propre à générer un faisceau lumineux comportant une onde optique à la pulsation de référence *ω* ; et,
- un modulateur (114) propre à moduler l'onde optique du faisceau lumineux générée par le laser mono-fréquence (112) selon ledit signal électrique de commande (S_{c}) pour obtenir en sortie un faisceau lumineux incident modulé de manière à comporter des ondes optiques à la pulsation *ω* et aux pulsations *ω* + 2*πf*₁ et/ou *ω* - 2*πf*₁.

3. Oscillateur (210) selon la revendication 1, dans lequel la source (211) est un laser bi-fréquence (212), propre à générer, selon ledit signal de commande (S_{c}), un faisceau lumineux incident comportant des ondes optiques à la pulsation *ω* et aux pulsations *ω* + 2*πf*₁ et/ou *ω* - 2*πf*₁*.*

4. Oscillateur (310) selon la revendication 1, dans lequel, le moyen de propagation (384) étant un premier moyen de propagation propre à produire une première onde acoustique retardée d'un premier retard (*τ*1) et le moyen de conversion (385) étant un premier moyen de conversion propre à délivrer un premier signal électrique de retard (S_{R1}) à partir de la première onde acoustique retardée, l'oscillateur comporte en outre un second moyen de propagation (386) propre à prélever l'onde acoustique générée par le résonateur optomécanique (382) et à la propager sur une distance de propagation (d₂) prédéterminée pour y introduire un second retard (*τ*2) de manière à produire une seconde onde acoustique retardée et un second moyen de conversion (387) propre à délivrer un second signal électrique de retard (S_{R2}) à partir de la seconde onde acoustique retardée, la boucle de commande (317) comportant un moyen de détermination d'un signal électrique d'erreur (Sₑ) élaboré à partir des premier et second signaux électriques de retard, le signal de commande (S_{c}) étant élaboré à partir du signal d'erreur (Sₑ).

5. Oscillateur selon l'une quelconque des revendications précédentes, dans lequel le résonateur optomécanique, le moyen de propagation acoustique et le moyen de conversion sont intégrés sur une même puce.

6. Oscillateur selon l'une quelconque des revendications précédentes, dans lequel le moyen de propagation acoustique est un guide d'onde accordé à la fréquence de référence f₁.

7. Oscillateur selon l'une quelconque des revendications précédentes, dans lequel le moyen de conversion comporte un matériau piézoélectrique et des électrodes interdigitées.

## Patentansprüche

1. Funkfrequenz-Oszillator (110), aufweisend:
- eine gesteuerte Quelle (111), welche imstande ist, einen einfallenden Lichtstrahl zu erzeugen, welcher zumindest eine optische Welle mit einem Referenzimpuls ω aufweist,
- einen optomechanischen Resonator (182), welcher eine optische Resonanz beim Referenzimpuls ω und eine mechanische Resonanz bei einer Referenzfrequenz f₁ hat, wobei der optomechanische Resonator imstande ist, ausgehend vom einfallenden Lichtstrahl einerseits einen austretenden Lichtstrahl, welcher optische Wellen mit Impulsen ω und *ω* - 2*πf*₁ aufweist, und andererseits eine akustische Welle mit der Referenzfrequenz f₁ zu erzeugen,
- eine Photodiode (118), welche imstande ist, ein elektrisches Nutzsignal (Sₒᵤₜ) bei der Referenzfrequenz f₁ ausgehend vom austretenden Lichtstrahl des optomechanischen Resonators (182) zu liefern,
**dadurch gekennzeichnet, dass** er aufweist:
- ein Mittel zur akustischen Propagation (184), welches imstande ist, die mittels des optomechanischen Resonators (182) erzeugte akustische Welle aufzunehmen und sie über eine vorbestimmte Propagationsentfernung (d) zu propagieren, um dort eine Verzögerung (τ) einzuführen, um eine verzögerte akustische Welle zu erzeugen,
- ein Mittel zum Umwandeln (185), welches imstande ist, die verzögerte akustische Welle am Ausgang des Mittels zur Propagation in ein elektrisches Verzögerungssignal (Sᵣ) umzuwandeln, welches eine Oszillationsfrequenz hat, welche gleich der Referenzfrequenz f₁ ist, und
- eine Steuerschleife (117), welche imstande ist, das Verzögerungssignal (Sᵣ) zu verarbeiten, um ein an die Quelle (111) angelegtes elektrisches Steuersignal (S_{c}) zu erhalten, wobei das elektrische Steuersignal eine Oszillationsfrequenz hat, welche gleich der Referenzfrequenz f₁ ist.

2. Oszillator (110) gemäß Anspruch 1, wobei die Quelle (111) aufweist:
- einen Monofrequenz-Laser (112), welcher imstande ist, einen Lichtstrahl zu erzeugen, welcher eine optische Welle mit dem Referenzimpuls ω aufweist, und
- einen Modulator (114), welcher imstande ist, die optische Welle des mittels des Monofrequenz-Lasers (112) erzeugten Lichtstrahls gemäß dem besagten elektrischen Steuersignal (S_{c}) zu modulieren, um am Ausgang einen modulierten einfallenden Lichtstrahl zu erhalten, um optische Wellen mit dem Impuls ω und mit den Impulsen *ω* + 2*πf*₁ und/oder *ω* - 2*πf*₁ aufzuweisen.

3. Oszillator (210) gemäß Anspruch 1, wobei die Quelle (211) ein Bifrequenz-Laser (212) ist, welcher imstande ist, gemäß dem besagten Steuersignal (S_{c}) einen einfallenden Lichtstrahl zu erzeugen, welcher optische Wellen mit dem Impuls ω und mit den Impulsen *ω* + 2*πf*₁ und/oder *ω* - 2*πf*₁ aufweist.

4. Oszillator (310) gemäß Anspruch 1, wobei das Mittel zur Propagation (384) ein erstes Mittel zur Propagation sind, welches imstande ist, eine erste akustische Welle zu erzeugen, welche um eine erste Verzögerung (*τ*1) verzögert ist, und das Mittel zum Umwandeln (385) ein erstes Mittel zum Umwandeln ist, welches imstande ist, ein erstes elektrisches Verzögerungssignal (S_{R1}) zu liefern, ausgehend von der ersten verzögerten akustischen Welle, wobei der Oszillator ferner aufweist ein zweites Mittel zur Propagation (386), welches imstande ist, die mittels des optomechanischen Resonators (382) erzeugte akustische Welle aufzunehmen und sie über eine vorbestimmte Propagationsentfernung (d₂) zu propagieren, um dort eine zweite Verzögerung (*τ*2) einzuführen, um eine zweite verzögerte akustische Welle zu erzeugen, und ein zweites Mittel zum Umwandeln (387), welches imstande ist, ein zweites elektrisches Verzögerungssignal (S_{R2}) zu liefern, ausgehend von der zweiten verzögerten akustischen Welle, wobei die Steuerschleife (317) ein Mittel zum Ermitteln eines elektrischen Fehlersignals (Sₑ) aufweist, welches ausgehend von dem ersten und dem zweiten elektrischen Verzögerungssignal erstellt wird, wobei das Steuersignal (S_{c}) ausgehend vom Fehlersignal (Sₑ) erstellt wird.

5. Oszillator gemäß irgendeinem der vorherigen Ansprüche, wobei der optomechanische Resonator, das Mittel zur akustischen Propagation und das Mittel zum Umwandeln auf einem selben Chip integriert sind.

6. Oszillator gemäß irgendeinem der vorherigen Ansprüche, wobei das Mittel zur akustischen Propagation ein Wellenleiter ist, welcher auf die Referenzfrequenz f₁ abgestimmt ist.

7. Oszillator gemäß irgendeinem der vorherigen Ansprüche, wobei das Mittel zum Umwandeln ein piezoelektrisches Material und ineinandergreifende Elektroden aufweist.

## Claims

1. A radiofrequency oscillator (110), including:
- a controlled source (111) able to generate an incident light beam including at least one optical wave at a reference pulsation frequency *ω*;
- an optomechanical resonator (182), having an optical resonance at the reference pulsation *ω* and a mechanical resonance at a reference frequency f₁, the optomechanical resonator being able, from the incident light beam, to generate an emergent light beam including optical waves at the pulsation frequencies *ω* and *ω* - 2*πf*₁, on the one hand, and an acoustic wave at the reference frequency f₁, on the other hand;
- a photodiode (118), able to deliver a working electrical signal (Sₒᵤₜ) at the reference frequency f₁ from the emergent light beam of the optomechanical resonator (182),
**characterized in that** it includes:
- an acoustic propagation means (184) able to take off the acoustic wave generated by the optomechanical resonator (182) and propagate it over a predetermined propagation distance (d) in order to introduce a delay (τ) therein so as to produce a delayed acoustic wave;
- a conversion means (185) able to convert the delayed acoustic wave at the output of the propagation means into an electrical delay signal (Sᵣ) having an oscillation frequency equal to the reference frequency f₁; and
- a control loop (117), able to process the delay signal (Sᵣ) in order to obtain an electrical control signal (S_{C}) applied to the source (111), the electrical control signal having an oscillation frequency equal to the reference frequency f₁.

2. The oscillator (110) according to claim 1, wherein the source (111) includes:
- a mono-frequency laser (112), able to generate a light beam including an optical wave at the reference pulsation frequency *ω*; and
- a modulator (114) able to modulate the optical wave of the light beam generated by the mono-frequency laser (112) according to said electrical control signal (S_{C}) in order to obtain, as output, an incident light beam modulated so as to include optical waves at the pulsation frequency *ω* and at the pulsation frequencies *ω* + 2*πf*₁ and/or *ω* - 2*πf*₁;

3. The oscillator (210) according to claim 1, wherein the source (211) is a dual frequency laser (212), able to generate, according to said control signal (S_{C}), an incident light beam including optical waves at the pulsation frequency *ω* and at the pulsation frequencies *ω* + 2*πf*₁ and/or *ω* - 2*πf*₁.

4. The oscillator (310) according to claim 1, wherein, the propagation means (384) being a first propagation means able to produce a first acoustic wave delayed by a first delay (*τ*1) and the conversion means (385) being a first conversion means able to deliver a first electrical delay signal (S_{R1}) from the first delayed acoustic wave, the oscillator further includes a second propagation means (386) able to take off the acoustic wave generated by the optomechanical resonator (382) and to propagate it over a predetermined propagation distance (d₂) to introduce a second delay (*τ*2) therein so as to produce a second delayed acoustic wave and a second conversion means (387) able to deliver a second electrical delay signal (S_{R2}) from the second delayed acoustic wave, the control loop (317) including a means for determining an electrical error signal (Sₑ) determined from first and second electrical delay signals, the control signal (S_{C}) being developed from the error signal (Sₑ).

5. The oscillator according to any one of the preceding claims, wherein the optomechanical resonator, the acoustic propagation means and the conversion means are integrated on a same chip.

6. The oscillator according to any one of the preceding claims, wherein the acoustic propagation means is a waveguide tuned to the reference frequency f₁.

7. The oscillator according to any one of the preceding claims, wherein the conversion means includes a piezoelectric material and interdigitated electrodes.
